# EUROPEAN PATENT APPLICATION

(11) **EP 4 687 173 A1**
(43) Date of publication of application: **04.02.2026**
(21) Application number: 25192661.4
(22) Date of filing: 29.07.2025
(51) Int. Cl.: H01L 23/495, H01L 23/48, H01L 21/48, H01L 25/07

(54) **A SEMICONDUCTOR PACKAGE, A HALF BRIDGE CLIP, AND A METHOD FOR MANUFACTURING SAID SEMICONDUCTOR PACKAGE**

(30) Priority: 31.07.2024 NL 2038368
(71) Applicant: Nexperia B.V., 6534 AB Nijmegen (NL)
(72) Inventor: Milo, Dolores, Manchester (GB); Yandoc, Ricardo Lagmay, Manchester (GB); Bonov, Ilian Emilov, Manchester, 1102ME (GB)
(74) Representative: Pjanovic, Ilija

(57) **Abstract**

A semiconductor package comprising a first and at least one further semiconductor device positioned at an interspacing from each other. Each of the semiconductor devices comprises a die paddle having a semiconductor die region, and a stacked semiconductor device having a first surface and a second surface opposite to the first surface, wherein the first surface is mounted to the semiconductor die region. The semiconductor package further comprises a half bridge clip having a first bridge clip portion electrically and mechanically connected to the second surface of the first semiconductor device and a further bridge clip portion electrically and mechanically connected to the second surface of the at least one further semiconductor device, wherein the half bridge clip comprises at least one conductive element electrically and mechanically connecting to at least one of the die paddles of the first and the at least one further semiconductor device.

## Description

### TECHNICAL FIELD

The present disclosure relates to a semiconductor package comprising two semiconductor devices, wherein a half bridge clip is provided to connect both. The disclosure further pertains to a half bridge clip and a method for manufacturing the semiconductor package comprising the half bridge clip.

### BACKGROUND OF THE DISCLOSURE

Half bridge semiconductor packages house the circuitry needed to control a pair of switching transistors, typically MOSFETs and IGBTs, to control the direction and flow of current to a load These packages play a crucial role in enabling electric vehicles (EV) technology and advanced driver-assistance systems (ADAS), because in these technologies the direction and the flow of current towards other electronic elements is constantly adjusted. The specific demands of the automotive environment, require these semiconductor packages to be efficient, reliable, and safe to operate.

The transistors in the half bridge semiconductor packages can be connected through wire bonds, which are cheap to manufacture, but can only handle a limited current. Since the automotive industry typically required more current to be controlled by the half bridge semiconductor package, bond clips are a more preferable choice, because they can allow greater current.

Unfortunately, these half bridge bond clips are heavier than the wire bond and therefore introduce a risk of tilting during the manufacturing process. This leads to unreliable or even malfunctioning half bridge packages. Furthermore, these errors arise during the molding step of the manufacturing process, making it difficult to visually inspect, whether the half bridge bond clip has tilted or not. This inevitably increases the cost of testing these semiconductor packages.

### SUMMARY OF THE DISCLOSURE

Accordingly, it is a goal of the present disclosure to provide a semiconductor package and a method of manufacturing one, as well as a half bridge clip, which mitigate the risk of tilting of the half bridge clip during the manufacturing process of a semiconductor package. Additionally, the semiconductor package may have a more favorable cost structure, since packaging and subsequent testing of the semiconductor dies can be done more efficiently.

This disclosure, in a first aspect, pertains to a semiconductor package comprising a first and at least one further semiconductor device positioned at an interspacing from each other. Each of the semiconductor devices comprises a die paddle having a semiconductor die region and a stacked semiconductor device having a first surface and a second surface opposite to the first surface, wherein the first surface is mounted to the semiconductor die region. The semiconductor package further comprises a half bridge clip having a first bridge clip portion electrically and mechanically connected to the second surface of the first semiconductor device and at least one further bridge clip portion electrically and mechanically connected to the second surface of the at least one further semiconductor device. The half bridge clip comprises at least one conductive element electrically and mechanically connected to at least one of the die paddles of the first and the at least one further semiconductor device.

A conductive element in the light of this disclosure may be understood as part of half bridge clip, which is bend, or a wire, a ribbon bond, or any other configuration of material, which has the functionality of closing the electric circuit of the half bridge clip on the die paddle and which offers mechanical stabilization to the half bridge clip. Furthermore, such conductive elements may be bonded or welded together by means of conductive adhesive, solder or the like.

Such a configuration, wherein the half bridge clip comprises a first bridge clip portion and at least one further bridge clip portion with each bridge clip portion being electrically and mechanically connected to the second surface of a respective stacked semiconductor device is beneficial for accommodating a height difference between the first and the at least one further stacked semiconductor device. In other words, a distance difference between the first and the second surface of each stacked semiconductor device can be accommodated with the configuration of the invention of the disclosure.

Furthermore, a configuration as described above is beneficial because of the presence of at least one conductive element that is electrically and mechanically connected to at least one of the die paddles of the first and the at least one further semiconductor device. Namely, this conductive element may offer mechanical stabilization to half bridge clip, such that tilting is prevented during the manufacturing process of the overall semiconductor package. It could, for instance, support the half bridge clips floating weight, which is located in between or away from the semiconductor die connecting portions of the half bridge clip. At least one conductive element may thus be provided on a half bridge clip in a location, such that the center of mass of the half bridge clip is at least substantially surrounded by multiple contact points of the half bridge clip.

Additionally, since the at least one conductive element is electrically and mechanically connected to at least one of the die paddles, it may also function as an electrical path required for the circuitry of the semiconductor package. Note that, in some cases it may be beneficial or even needed for the internal electronic circuit to electrically connect the conductive element to multiple die paddles.

A skilled person in the art will understand that a semiconductor package according to the disclosure may in particular be used for power electronics, such as DFN/QFN, wherein both of the stacked semiconductor devices could be Gallium Nitride HEMT/MOSFET stacks, wherein one semiconductor die connecting portion of the half bridge clip would be connected to the HEMT part of the first stacked semiconductor device and a further semiconductor die connecting portion would be connected to the MOSFET part of the further stacked semiconductor device. In that regard one terminal may be connected to one of the die paddles, such that the electronic circuit of the half bridge is completed.

Additionally, a stacked semiconductor device could also be a single semiconductor die such as a simple sensor instead of a stack semiconductor dies. Such a stacked semiconductor device only has two surfaces and its functionality sandwiched in between them. In the latter case of a stack of semiconductor dies, the second surface of the stacked semiconductor device is thus not limited to be the outer most surface of the stacked semiconductor device. It could for example also be an intermediate surface of the stack, however it should be considered as the second active surface side of the semiconductor die stack.

It should also be noted that a half bridge clip may also comprise lead terminals, which could extend outside of the semiconductor package after manufacturing, which can be used to connect the semiconductor package to further electronic circuitry.

In a first example of the disclosure, the at least one conductive element extends from the first bridge clip portion and connects to the die paddle of the first semiconductor device.

Alternatively, in a second example, the at least one conductive element extends from the first bridge clip portion and connects to the die paddle of the at least one further semiconductor device.

Whether the at least one conductive element protrudes from the first bridge clip portion towards the die paddle of the first or the at least one further semiconductor device depends on the requirements and the actual layout of the semiconductor package. For instance, form factor requirements may necessitate the half bridge clip to be formed as an elongated shape, such that the center of mass is above the first semiconductor device, whereas the required electrical connection should be made on the die paddle of at least one further semiconductor device. In that case, it is more beneficial to have the at least one conductive element extends from the first bridge clip portion and to extend and connect to the die paddle of the at least one further semiconductor device.

The semiconductor package, according to another example of the disclosure, comprises at least one conductive element positioned on a side edge of the half bridge clip.

The benefit of having at least one conductive element positioned on a side edge of the half bridge clip may be that due to space limitations on the die paddle, no available surface room is present at the desired location to support the weight of the half bridge clip or its dangling/floating portion. Therefore, at least one conductive element may be positioned on a side edge to provide a tri- or multipod situation, wherein the weight of the half bridge clip is not supported from underneath but from its sides, thereby creating a more stable geometry and weight balance.

In yet another example, the at least one conductive element is formed as any of a I-, V-, C-, G-, W-, S-, J-, L-lead.

The shape of a at least one conductive element determines how much stability and electrical and mechanical connectivity can be offered by the at least one conductive element, since that defines the contact area between the die paddle and the half bridge clip, but it further also defines the amount of surface area for solder or conductive adhesive to adhere onto for making said electrical and mechanical connection. For instance, a W-lead has twice the amount of contact area than a V-lead, but on the other hand a V-lead has a smaller form factor than a W-lead. The above mentioned leads all have benefits and drawbacks, which determine their use cases based on the space availability and requirements of the electrical and mechanical connection of the at least one conductive element.

In a further example, the at least one conductive element comprises a plurality of conductive elements.

Additionally, in another example, the plurality of conductive elements are electrically and mechanically connected to the same die paddle of one of the first and the at least one further semiconductor devices.

Having a plurality of conductive elements allows for establishing electrical and mechanical connections on different locations of the half bridge clip and die paddle. Especially, when connected to the same die paddle the voltage potential may be considered to be equal for all conductive elements, such that when breakage of a conductive element connection occurs, redundant connections may still be present. Furthermore, the locations of the plurality of conductive elements may be provided such that they substantially surround the center of mass of the half bridge clip ensuring stability due to geometric weight distribution.

A second aspect the disclosure pertains to is a half bridge clip adapted for use in a semiconductor package, comprising a first bridge clip portion adapted to electrically and mechanically connect to a first semiconductor device of the semiconductor package and a further bridge clip portion adapted to electrically and mechanically connect to at least one further semiconductor device of the semiconductor package. The half bridge clip further comprises at least one conductive element adapted to electrically and mechanically connect to at least one die paddle of the first and the at least one further semiconductor device.

A half bridge clip in this configuration mitigates the risk of tilting due to the presence of the at least one conductive element. This conductive element may support the otherwise floating weight of the half bridge clip by being adapted to mechanically connect to a die paddle. Additionally, a half bridge with such configuration enables the conductive element to function as a part of the circuitry, because of the presence of both an electrical connection to a lead frame, as well as electrical connections to at least two different stacked semiconductor devices (being the first and at least one further stacked semiconductor device).

In a third aspect, the disclosure pertains to a method for manufacturing a semiconductor package, comprising the steps of:
i) providing a first and at least one further semiconductor device, wherein each semiconductor device is manufactured by:
   a) providing a die paddle having a semiconductor die region;
   b) mounting a stacked semiconductor device, having a first surface and a second surface opposite to the first surface, with its first surface to the semiconductor die region;
ii) connecting a half bridge clip electrically and mechanically to the second surface of the stacked semiconductor device of each of the semiconductor devices; and iii) further connecting at least one conductive element of the half bridge clip electrically and mechanically to at least one of the die paddles of the first and the at least one further semiconductor device.

A method of manufacturing with the above-described steps provides a semiconductor package which reduces the risk of tilting of a half bridge clip during manufacturing. This method may especially be applicable for cases wherein the height of the different stacked semiconductor devices are different. Furthermore, since the half bridge clip is provided with at least one conductive element which is electrically and mechanically connected to a die paddle, this at least one conductive element ensures that the otherwise floating weight of the half bridge clip is supported and maintained at its position. Additionally, the at least one conductive element may also partake in the electrical circuit needed in the semiconductor package by being electrically connected to the at least one lead frame.

In an example of the method, step iii) of further connecting the at least one conductive element of the half bridge clip is performed by using solder or conductive adhesive by reflow, diffusion, ultrasonic bonding, baking, sintering, or another process to make an electric and mechanical connection.

These different connection techniques may be used depending on the application of the semiconductor package and the requirements of the manufacturing process. For instance, it might be the case that a heat sensitive stacked semiconductor device is used, such that reflow, baking or sintering can no longer be employed, whereas these are typically the common processes to liquify solder and subsequently solidify on the die paddle and the at least one conductive element.

In yet another example of the method, the half bridge clip is formed through etching, stamping and/or bending.

To manufacture the desired half bridge clip, one could for instance first stamp an outlined shape of the half bridge clip out of a piece of copper, whereafter different bending processes are utilized to bend and form the half bridge clip, such that the half bridge portions that connect to the stacked semiconductor devices have the correct height difference. In that same process the at least one clip portions may be formed extending towards to die paddles, such that they can act as supports to mitigate the risk of tilting of the half bridge clip.

In the last example of the method, the at least one conductive element of the half bridge comprises a plurality of conductive elements, which are all electrically and mechanically connected during step iii) to the same die paddle of the of the first and the at least one further semiconductor device.

Providing a plurality of conductive elements ensures greater stability of the half bridge clip due to mechanical connections and could even offer redundancy during malfunctioning of one of the electrical connections with the die paddle. Furthermore, by connecting all of the plurality of clip portions to the same die paddle, it can be assured that the half bridge clip can partake in the electronic circuitry of the semiconductor package as well as providing said redundancy.

All in all, a semiconductor package or a method of fabricating one as well as a half bridge clip as described above, ensure that tilting of a half bridge clip in semiconductor packaging is reduced, thereby reducing the packaging costs, simplifying the testing, and offering similar to even greater robustness of the overall semiconductor package.

### BRIEF DESCRIPTION OF THE DRAWINGS

Figure 1 shows a top view of an example according to the disclosure of a semiconductor package comprising a half bridge clip
Figure 2 shows a top view of another example according to the disclosure of a semiconductor package comprising a half bridge clip
Figure 3 shows a top view of yet another example according to the disclosure of a semiconductor package comprising a half bridge clip
Figures 4A-B shows a side view of an example according to the disclosure of a semiconductor package comprising a half bridge clip
Figures 5A-G show different leads of the conductive element of the half bridge clip
Figure 6 shows a top view of a further example according to the disclosure of a semiconductor package comprising a half bridge clip
Figure 7 shows a top view of another further example according to the disclosure of a semiconductor package comprising a half bridge clip
Figure 8 shows a top view of yet another example according to the disclosure of a semiconductor package comprising a half bridge clip
Figure 9 shows a top view of another example according to the disclosure of a semiconductor package comprising a half bridge clip

### DETAILED DESCRIPTION OF THE DISCLOSURE

For a proper understanding of the disclosure, in the detailed description below corresponding elements or parts of the disclosure will be denoted with identical reference numerals in the drawings.

In prior art semiconductor packages, because of the weight of half bridge clips, a risk of tilting during the manufacturing of said prior art semiconductor package 1000 is present. This leads to unreliable or even malfunctioning semiconductor packages when they comprise half bridge clips. The semiconductor package 1000 and the half bridge clip 400 according to the disclosures mitigate the risk of tilting of the half bridge clip.

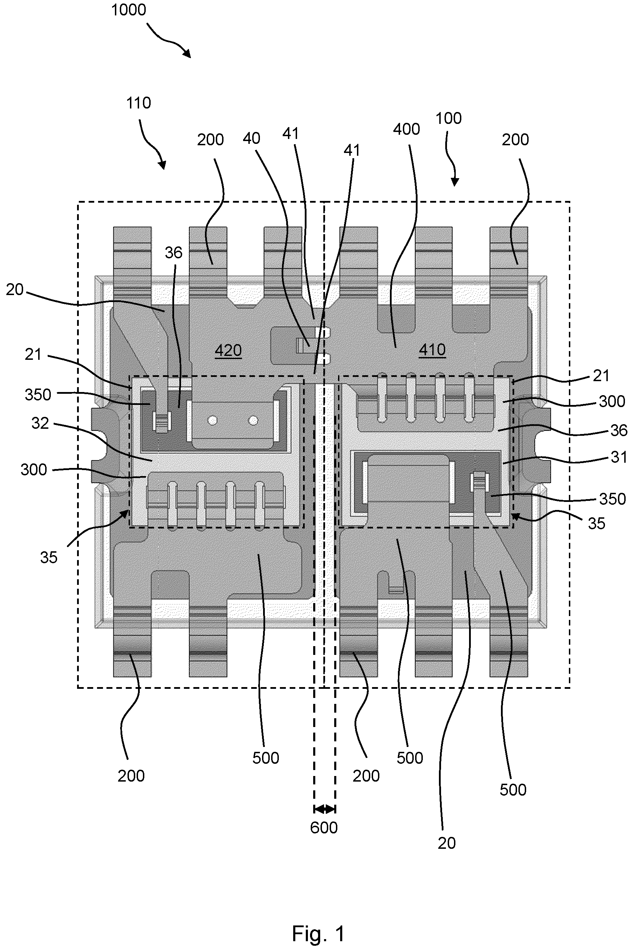

A semiconductor package 1000 according to the disclosure is shown in Fig. 1, wherein a semiconductor package 1000 comprises a first 100 and at least one further semiconductor device 110 positioned at an interspacing 600 from each other. Each of the semiconductor devices comprises a die paddle 20 having a semiconductor die region 21 and a stacked semiconductor device having a first surface 35 and a second surface 36 opposite to the first surface 35, wherein the first surface 35 is mounted to the semiconductor die region 21. The semiconductor package 1000 further comprises a half bridge clip 400 having a first bridge clip portion 410 electrically and mechanically connected to the second surface 36 of the first semiconductor device 100 and at least one further bridge clip portion 420 electrically and mechanically connected to the second surface 36 of the at least one further semiconductor device. The half bridge clip 400 comprises at least one conductive element 40 electrically and mechanically connected to at least one of the die paddles of the first 100 and the at least one further semiconductor device 110.

The conductive element 40 shown in Fig. 1 is part of half bridge clip 400, by being a portion of the half bridge clip that is bent. However, the conductive element 40 is not limited thereto and could also be a separate element made of another material at least electrically and mechanically connected to at least one die paddle and to the half bridge clip 400. For instance, it may be a wire, a ribbon bond, or any other configuration of material, which has the functionality of closing the electric circuit of the half bridge clip 400 on the at least one die paddle and which offers mechanical stabilization to the half bridge clip 400. Furthermore, such conductive elements 40 may be bonded or welded together by means of conductive adhesive, solder or the like.

In the example in Fig. 1, the half bridge clip 400 and bond clips further comprise lead terminals 200 adapted to connect the semiconductor package 1000 to further circuitry. In particular the half bridge clip 400 of the example of Fig. 1 is shown to connect to two different stacked semiconductor devices 31/32, which have different height dimensions. The stacked semiconductor device 31 of the first semiconductor device 100 is a stack of a MOSFET 350 and a HEMT 300, wherein the first surface 35 of the stacked semiconductor device coincides with a surface of the HEMT and wherein the second surface 36 of the stacked semiconductor device 31 coincides with another opposite surface of the HEMT. The at least further stacked semiconductor device 32 of the at least one further semiconductor device 110 on the other hand is also a HEMT 300 /MOSFET 350 stack, but the first surface 35 of the further stacked semiconductor device 32 coincides with a surface of the HEMT 300 and the second surface 36 of the stacked semiconductor device coincides with a surface of the MOSFET 350, causing the half bridge clip 400 to have different bend characteristics between the first bridge clip portion 410 and the at least one further bridge clip portion 420. Since the half bridge clip 400 is connected to two different stacked semiconductor devices 31/32, it also forms part of the internal circuitry of the semiconductor package.

A stacked semiconductor device 31/32 may thus be understood as a collective naming for a single semiconductor die or a stack of semiconductor dies having some type of electronic functionality. A simple stacked semiconductor device 31/32 (comprising only one semiconductor die) has two opposing surfaces 35/36 and its functionality is sandwiched in between them. In such case, the first surface 35 connected to the die paddle 20 coincides with a surface of the semiconductor die, and the second surface 36 coincides with the opposite surface of that same semiconductor die. In order words, the first 35 and the second surfaces 36 then also are the outer most surfaces of the stacked semiconductor device 31/32.

Alternatively, the stacked semiconductor device 31/32 comprises a stack of semiconductor dies, wherein the first surface 35 coincides with the bottom most semiconductor die of the stack. The second surface 36, in the case of a semiconductor stack, is not limited to be the outermost surface of the stacked semiconductor device 31/32. Namely, it may also be an intermediate surface of the stack, but could potentially also be the outer most surface. The actual position depends exactly on the type of semiconductor stack and its electrical functioning, which dictates where the electrical connection should be made.

Fig 1. further shows a conductive element 40 that is electrically and mechanically connected to the die paddle 20 of the at least one further semiconductor device. Notably, the conductive element 40 extends from the first bridge clip portion 410 and thereby crosses over the interspacing 600 between the two semiconductor devices. Such a configuration may be required, when the conductive element 40 forms another electrical circuit connection with the die paddle 20 of the at least one further semiconductor device 110 and the center of mass of the half bridge clip 400 is located over the first semiconductor device 100. This way, a stable electrical and mechanical connection is formed which both acts as a support of the half bridge clip 400 and as active connection of the internal circuitry.

The conductive element 40 may thus not only offer an electrical connection, but also offers a mechanical stabilization for the half bridge clip 400 to rest on. This way, tilting is prevented during the manufacturing process of the overall semiconductor package. The mechanical stabilization is even further improved by stable solder or conductive adhesive connection between the conductive element 40 and die paddle.

Furthermore, the half bridge portion crossing over the interspacing 600 between the two bridge clip portions in Fig. 1 is shown to comprise two further sub portions. The dimensions and the thickness all depend on the specific requirements of the semiconductor package 1000 and for power electronic applications would likely require a configuration as shown in this figure, because the cross-sectional area of the half bridge clip 400 along the interspacing 600 is large enough for current to flow through.

A half bridge clip 400 according to the disclosure offers low inductance, such that the performance of the semiconductor package 1000 is equal even better than a semiconductor package 1000 comprising a half bridge clip 400 without a conductive element.

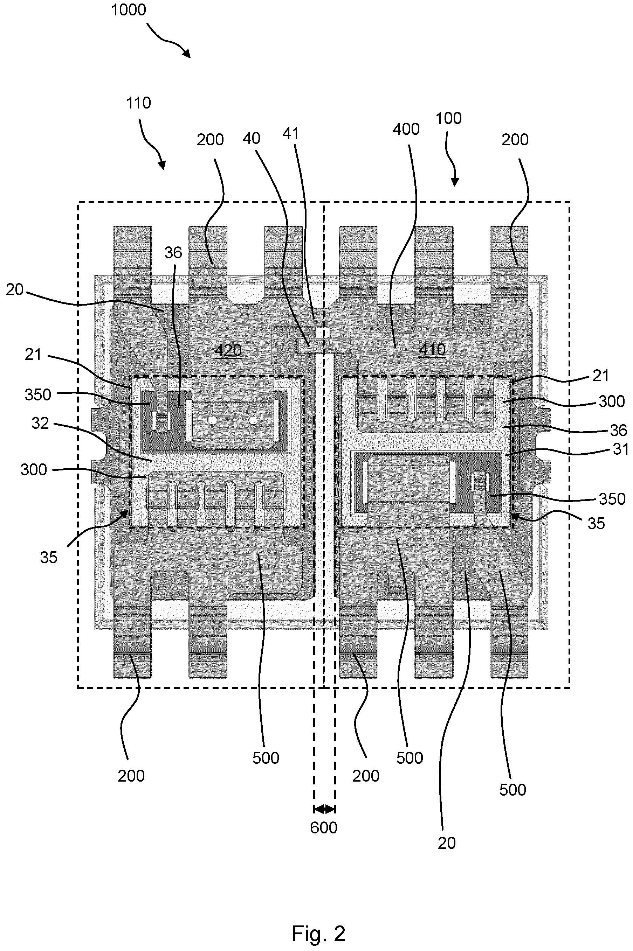

Another example of a semiconductor package 1000 according to the disclosure is shown in Fig. 2, wherein a similar semiconductor package 1000 with similar components is shown, except for the half bridge portion crossing over the interspacing 600 between the two bridge clip portions.

In Fig. 2, the half bridge portion crossing over the interspacing 600 between the two bridge clip portions is shown to only comprise one further subportion 41. Such a configuration could potentially handle less current flow through the half bridge clip 400, because of a lesser cross-sectional area than the half bridge in Fig. 1. However, due to the open structure of this configuration, the half bridge clip 400 is easier to manufacture, because greater accessibility for bending processes exist. This would therefore result is a lower cost structure of the entire semiconductor package 1000, while only limiting the current throughput slightly.

Still in Fig. 2, the conductive element 40 offers mechanical stabilization to the half bridge clip 400 such that tilting is prevented, and the conductive element 40 additionally offers an electrical connection of the die paddle 20 to partake in the internal circuitry of the semiconductor package.

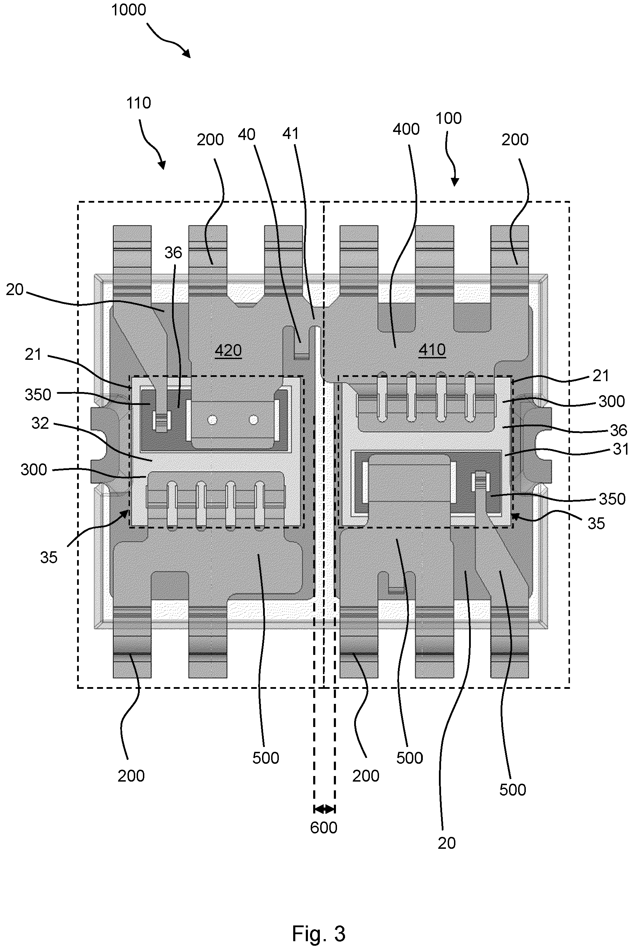

A further example of a semiconductor package 1000 according to the disclosure is shown in Fig. 3, which shows a similar semiconductor package 1000 as in Fig. 1 and Fig. 2. However, in Fig. 3 the conductive element 40 extends from the first bridge clip portion 410 and connects to the die paddle 20 of the at least one further semiconductor device 110.

Such a configuration is beneficial when the center of mass of the half bridge clip 400 is also located above the first semiconductor device 100, since then mechanical support can directly be offered underneath the heaviest part of the half bridge clip.

Furthermore, due to the configuration of Fig. 3, the at least one conductive element 40 is easy to manufacture, because of accessibility for bending processes.

Fig. 3 further shows that the portion of the half bridge clip 400 crossing over the interspacing 600 comprises only one further subportion 41, similarly as in Fig. 2. In this case, again, the open configuration makes that the manufacturing of the half bridge clip 400 becomes easier and thus cheaper, whereas the presence of only one subportion 41 reduces the amount of maximum transferable current through the half bridge clip 400 slightly.

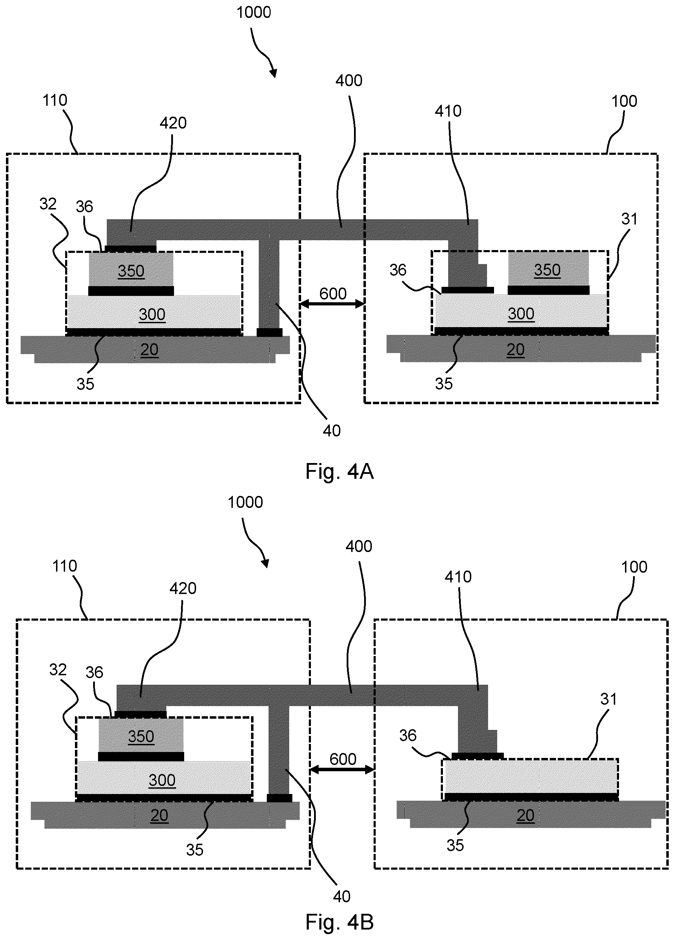

In Fig 4A a first example of a side view of semiconductor package according to the disclosure is shown. Here, the half bridge clip 400 connects to two different stacked semiconductor devices 31/32, which have different height dimensions. The stacked semiconductor device 31 of the first semiconductor device 100 is a stack of a HEMT 300 and a MOSFET 350, wherein the first surface 35 of the stacked semiconductor device coincides with a surface of the HEMT 300 and wherein the second surface 36 of the stacked semiconductor device 31 coincides with another opposite surface of that same HEMT 300.

The at least further stacked semiconductor device 32 of the at least one further semiconductor device 110 on the other hand comprises also a HEMT 300 /MOSFET 350 stack. This time, the first surface 35 of the further stacked semiconductor device 32 coincides with a surface of the HEMT, but the second surface 36 of the stacked semiconductor device coincides with a surface of the MOSFET 350, creating a height difference between the two second surfaces 36. Therefore, the half bridge clip 400 has to have different bend characteristics between the first bridge clip portion 410 and the at least one further bridge clip portion 420. The half bridge clip 400 is connected to two different stacked semiconductor devices 31/32, and further connected to the die paddle 20, thereby forming part of the internal circuitry of the semiconductor package.

In Fig 4B a second example of a side view of semiconductor package according to the disclosure is shown. Here again, the half bridge clip 400 connects to two different stacked semiconductor devices 31/32, which have different height dimensions. The stacked semiconductor device 31 of the first semiconductor device 100, this time, comprises only one semiconductor die, such that the first surface 35 of the stacked semiconductor device coincides with a surface semiconductor die and such that the second surface 36 of the stacked semiconductor device 31 coincides with another opposite surface of said semiconductor die.

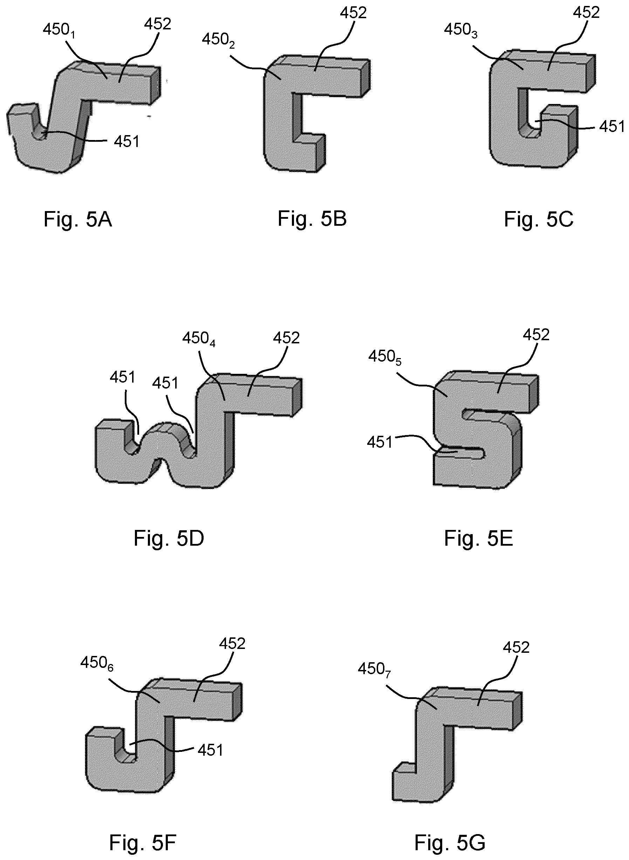

The at least further stacked semiconductor device 32 of the at least one further semiconductor device 110 on the other hand comprises a HEMT 300 /MOSFET 350 stack, similar to Fig. 5A. Again, the half bridge clip 400 has to overcome a height difference between the two stacked semiconductor devices, by having different bend characteristics between the first bridge clip portion 410 and the at least one further bridge clip portion 420. In such an example, for instance, the first stacked semiconductor device 31 may function as a sensor or the like, thereby only needing one semiconductor die to function.

Figs. 5A to 5G show different lead forms of the at least one conductive element. For example, in Fig. 5A a V-lead 450₁ is shown, which has small contact area with the die paddle 20, but is easy to manufacture and offers a recess 451 for solder or conductive adhesive to collect into during the manufacturing process. In Fig. 5B, a C-lead 450₂ of the conductive element 40 is shown, which offers a greater contact area with the die paddle 20 than the V-lead 450, would. However, it does not comprise a recess 451 for solder or conductive adhesive to collect into. This recess 451 is, however, present on a G-lead 450₃ as shown in Fig. 5C, which also offers similar contact area with the die paddle 20 as a C-lead 450₂ would. This way, the G-lead 450₃ has a large contact area and comprises a recess 451 for solder or conductive adhesive to collect into, but this would make the conductive element 40 more costly to manufacture. Fig. 5D shows a W-lead 450₄, which has twice the contact area and twice the recess 451 of a V-lead 450₁. In Fig. 5E, an S-lead 450₅ is shown, which has a large contact area and a large extended recess, and in Fig. 5F a J-lead 450₆ is shown, which would function similarly as the G-lead 450₃, but has a greater form factor due to oppositely placed top lead part 452. Lastly, an L-lead 450₇ is shown in Fig. 5G, which would be the easiest to manufacture, but only offers a small contact area and has no recess 451 for solder or conductive adhesive to collect into.

All in all, these different lead forms are useful in different applications of the semiconductor package 1000, depending on the specific requirements. For example, in case a lot of current needs to be conducted into the die paddle, one might rather utilize a G-, W-, S-, or a J-lead, (450₃, 450₄, 450₅, 450₆, respectively), since they offer a large contact area with the die paddle. Whereas to obtain a stronger mechanical connection, one might want to utilize a V-, G-, W-, S-, or J-lead, (450₁, 450₃, 450₄, 450₅, 450₆, respectively), since they offer recesses for solder or conductive adhesive to collect into.

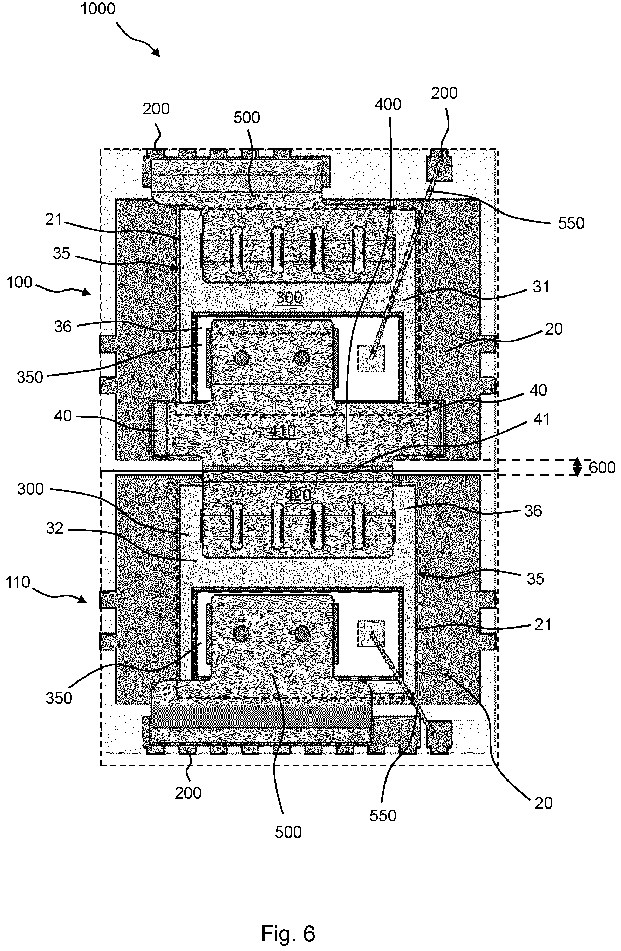

In the example of Fig. 6, another configuration is shown of a semiconductor package 1000 according to the disclosure. In this particular configuration the layout of the semiconductor package 1000 is different than the layout shown in Figs. 1-3. Now, the half bridge clip 400 does not comprise any lead terminals 200 that extend out of the body of the semiconductor package, such that the half bridge clip 400 is located entirely internal in the semiconductor package.

The semiconductor package 1000, therefore, also comprises bond wires 550, to connect parts of the internal circuitry to lead terminals 200, which extend out of the semiconductor package 1000 underneath the die paddles 20.

The half bridge clip 400 is electrically and mechanically connected with its first bridge clip portion 410 to the second surface 36 of the first semiconductor device 100 and electrically and mechanically connected with its at least one further bridge clip portion 420 to the second surface 36 of the at least one further semiconductor device. This way, the half bridge clip 400 extends over the interspacing 600 between the two semiconductor devices.

The half bridge clip 400 further comprises at least one conductive element 40 electrically and mechanically connected to at least one of the die paddles of the first 100 and the at least one further semiconductor device 110. As shown in Fig. 6, the at least one conductive element 40 comprises a plurality of conductive elements 40, in particular in this example two conductive elements 40, and all of these conductive elements 40 are electrically and mechanically connected to the same die paddle.

Due to size constraints in the layout of Fig. 6, the conductive elements 40 are positioned on a side edge of the half bridge clip 400, such that they offer mechanical stability much like a multipod having legs extending far away from the center of mass. This way, it is ensured that the half bridge clip 400 does not tilt during manufacturing of the semiconductor package.

Furthermore, these conductive elements 40 are electrically connected to the die paddle 20 to partake in the internal electrical circuit of the semiconductor package. A half bridge clip 400 having this configuration allows for high currents to be used by the semiconductor package 1000, because of the large cross-section of the half bridge clip 400 along the interspacing 600 between the two semiconductors devices.

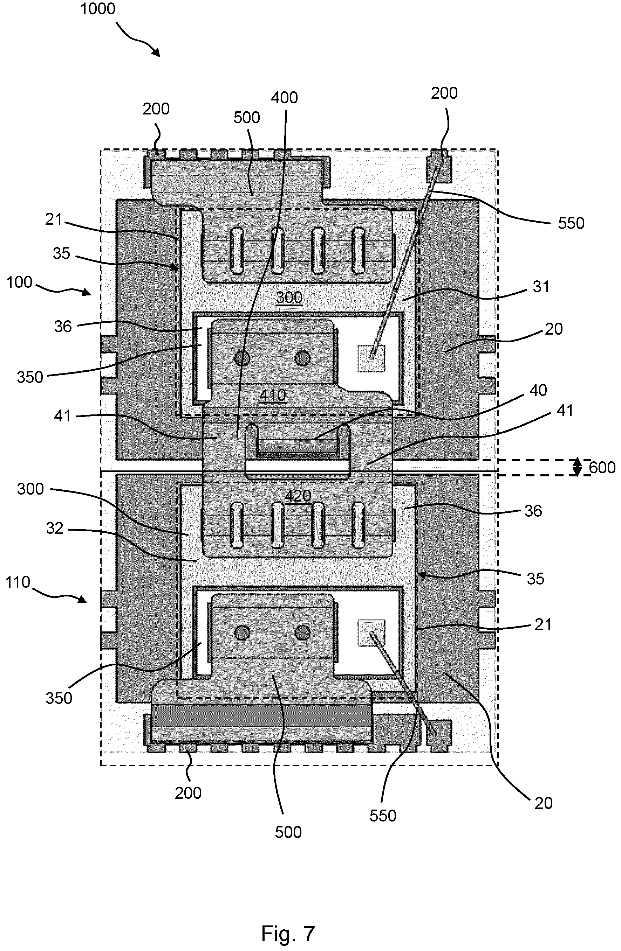

In Fig. 7 another example of a half bridge clip 400 in a semiconductor package 1000 according to the disclosure is shown. In this particular semiconductor package 1000, there are no size constraints, such that there is room for a conductive element 40 to be connected in the proximity of the interspacing.

Fig. 7 shows that the conductive element 40 extends from the first bridge clip portion 410 and connects to the die paddle 20 of the first semiconductor device 100. Because of this, the half bridge portion crossing over the interspacing 600 between the two bridge clip portions comprises two further subportions 41.

With respect to Fig. 6, there is less cross-sectional area in Fig. 7 of the half bridge clip 400, such that the maximum allowed current through the half bridge clip 400 would be lower. However, to manufacture the half bridge clip 400 in Fig. 7 less half bridge material is needed such that the manufacturing costs of the entire semiconductor package 1000 are lower.

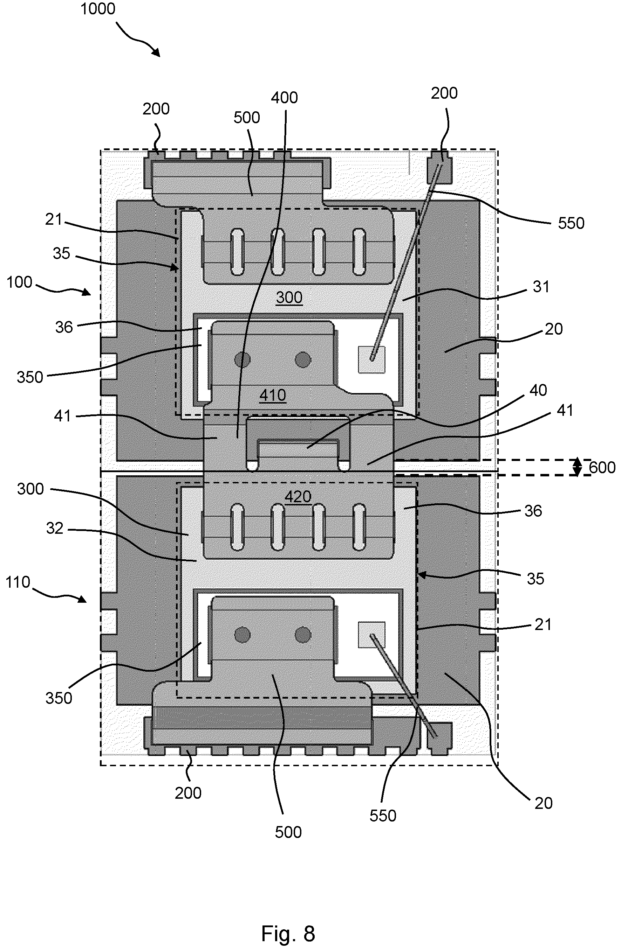

In Fig. 8, a semiconductor package 1000 is shown, wherein the half bridge clip 400 comprises one conductive element 40 which extends from the first bridge clip portion 410 and connects to the die paddle 20 of the at least one further semiconductor device.

This configuration is similar to the design of the half bridge clip 400 in Fig. 7, but it has a different center of mass, since more mass of the half bridge clip 400 is located above the first bridge clip 400, due to the conductive element 40 extending over the interspacing 600 between the two semiconductor devices. A configuration as in Fig. 8 would be beneficial in cases, where further processing steps are required on the at least one further semiconductor device. Since a stronger mechanical connection is to be expected on the first bridge clip portion 410 of the half bridge clip 400 on the side of the first semiconductor device 100, additional processing on the at least one further semiconductor device 110 would have less impact on the position, orientation and tilt of the half bridge clip.

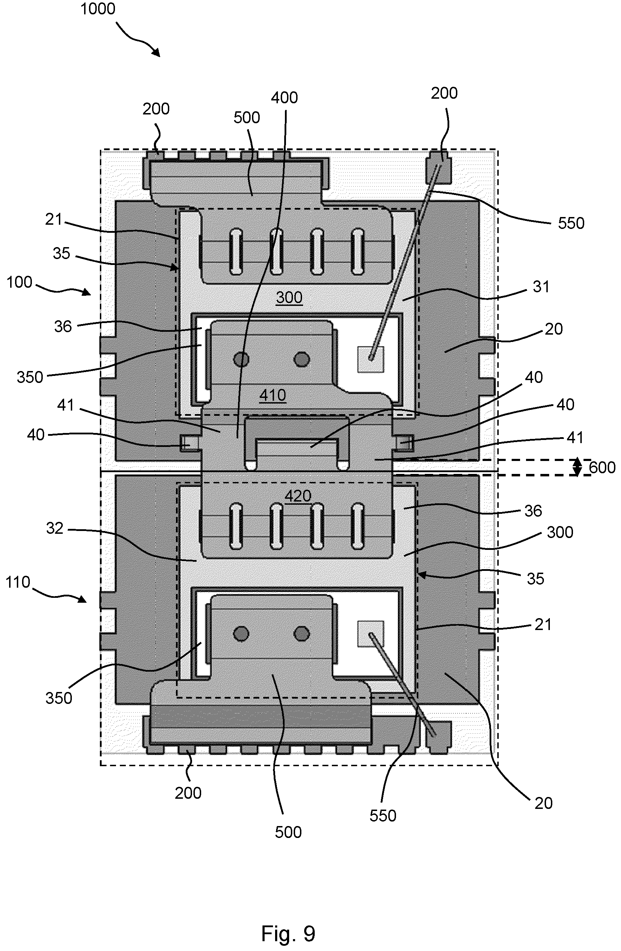

In another example according to the disclosure, the configuration of Fig. 8 is extended with two more conductive elements 40 positioned on the side edge of the half bridge clip 400, such that a greater mechanical and electrical connection is established. This is shown in Fig. 9, wherein all conductive elements 40 are connected to the same die paddle; namely the at least one further die paddle. One conductive element 40 extends over the interspacing 600 between the two semiconductor devices and two further conductive elements 40 are positioned on side edges of the half bridge clip 400 above the at least one further semiconductor device 110, connected to the at least one further die paddle 20.

In this configuration, more current can be provided through the half bridge clip 400 to the die paddle 20 or vice versa than would be possible with the semiconductor package 1000 of Fig. 8, but it would require additional steps in the manufacturing of the half bridge clip 400, such as the bending of the two side edge conductive elements 40.

It should be noted that the skilled person in the art would understand that at least one conductive element 40 is employed in order to prevent tilting of the half bridge clip 400 by providing mechanical stability. The figures shown in this disclosure are thus to be understood as examples of this, and should not be considered to limit the disclosure. Furthermore, one could prolong, extend, half, rotate, and/or translate any of the conductive elements 40 shown in the figures to still obtain the same tilt preventing effect.

The semiconductor packages shown in the figures thus ensure that tilting of a half bridge clip 400 is reduced during the manufacturing of said semiconductor package. This reduces the costs of manufacturing because of higher yield, simplifies the testing, and offering similar to even greater robustness of the overall semiconductor package.

### LIST OF REFERENCE NUMERALS USED

- 1000: semiconductor package
- 100: first semiconductor device
- 110: at least one further semiconductor device
- 20: die paddle
- 21: semiconductor die region
- 31: first stacked semiconductor device
- 32: at least one further stacked semiconductor device
- 35: first surface of the stacked semiconductor device
- 36: second surface of the stacked semiconductor device
- 40: conductive element
- 41: subportion
- 200: lead terminal
- 300: HEMT
- 350: MOSFET
- 400: half bridge clip
- 410: first bridge clip portion
- 420: at least one further bridge clip portion
- 450₁-...450₇: lead of conductive element
- 451: recess
- 452: top of lead
- 500: bond clip
- 550: bond wire
- 600: interspacing

## Claims

1. A semiconductor package comprising a first and at least one further semiconductor device positioned at an interspacing from each other, wherein each of the semiconductor devices comprises:
- a die paddle having a semiconductor die region;
- a stacked semiconductor device having a first surface and a second surface opposite to the first surface, wherein the first surface is mounted to the semiconductor die region;
the semiconductor package further comprising a half bridge clip having a first bridge clip portion electrically and mechanically connected to the second surface of the first semiconductor device and a further bridge clip portion electrically and mechanically connected to the second surface of the at least one further semiconductor device, wherein the half bridge clip comprises at least one conductive element electrically and mechanically connecting to at least one of the die paddles of the first and the at least one further semiconductor device.

2. The semiconductor package according to claim 1, wherein the at least one conductive element extends from the first bridge clip portion and connects to the die paddle of the first semiconductor device.

3. The semiconductor package according to any of the preceding claims, wherein the at least one conductive element extends from the first bridge clip portion and connects to the die paddle of the at least one further semiconductor device.

4. The semiconductor package according to any of the preceding claims, wherein the at least one conductive element is positioned on a side edge of the half bridge clip.

5. The semiconductor package according to any of the preceding claims, wherein the at least one conductive element is formed as any of a I-, V-, C-, G-, W-, S-, J-, L-lead.

6. The semiconductor package according to any of the preceding claims, wherein the at least one conductive element comprises a plurality of conductive elements.

7. The semiconductor package according to claim 6, wherein the plurality of conductive elements are electrically and mechanically connected to the same die paddle of one of the first and the at least one further semiconductor devices.

8. A half bridge clip adapted for use in a semiconductor package according to any of the preceding claims, comprising a first bridge clip portion adapted to electrically and mechanically connect to a first semiconductor device of the semiconductor package and a further bridge clip portion adapted to electrically and mechanically connect to at least one further semiconductor device of the semiconductor package, wherein the half bridge clip further comprises at least one conductive element adapted to electrically and mechanically connect to at least one die paddle of the first and the at least one further semiconductor device.

9. A method for manufacturing a semiconductor package according to the claims 1-7, comprising the steps of:
i) providing a first and at least one further semiconductor device, wherein each of semiconductor device is manufactured by:
a) providing a die paddle having a semiconductor die region;
b) mounting a stacked semiconductor device, having a first surface and a second surface opposite to the first surface, with its first surface to the semiconductor die region;
ii) connecting a half bridge clip electrically and mechanically to the second surface of the stacked semiconductor device of each of the semiconductor devices; and
iii) further connecting at least one conductive element of the half bridge clip electrically and mechanically to at least one of the die paddles of the first and the at least one further semiconductor device.

10. The method according to claim 9, wherein step iii) of further connecting the at least one conductive element of the half bridge clip is performed by using solder or conductive adhesive by reflow, diffusion, ultrasonic bonding, baking, sintering, or another process to make an electric and mechanical connection.

11. The method according to claim 9 or 10, wherein the half bridge clip is formed through etching, stamping and/or bending.

12. The method according to claims 9-11, wherein the at least one conductive element of the half bridge clip comprises a plurality of conductive elements, which are all electrically and mechanically connected during step iii) to the same die paddle of the first and the at least one further semiconductor device.
